(19) Europäisches Patentamt
European Patent Office
Office européen des brevets

(11) **EP 2 541 268 B1**

(12) **FASCICULE DE BREVET EUROPEEN**

(45) Date de publication et mention
de la délivrance du brevet:
**16.03.2016 Bulletin 2016/11**

(51) Int Cl.:
***G01R 33/26*** *(2006.01)*

(21) Numéro de dépôt: **12174067.4**

(22) Date de dépôt: **28.06.2012**

(54) **Magnétomètre vectoriel à haute résolution et de haute précision**

Hochauflösender vektorieller Hochpräzisionsmagnetometer

High-resolution, high-precision vector magnetometer

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.07.2011 FR 1155963**

(43) Date de publication de la demande:
**02.01.2013 Bulletin 2013/01**

(73) Titulaire: **Commissariat à l'Énergie Atomique
et aux Énergies Alternatives
75015 Paris (FR)**

(72) Inventeurs:
• **Jager, Thomas
38000 Grenoble (FR)**
• **Leger, Jean-Michel
38190 Villard Bonnot (FR)**

(74) Mandataire: **Augarde, Eric
Brevalex
56 Boulevard de l'Embouchure,
Bât. B
B.P. 27519
31075 Toulouse Cedex 2 (FR)**

(56) Documents cités:
**EP-A1- 0 579 537      EP-A1- 0 964 260
EP-A1- 1 344 075      FR-A1- 2 663 430
FR-A1- 2 713 347**

• **O GRAVRAND ET AL: "On the calibration of a
vectorial 4He pumped magnetometer", EARTH
PLANETS SPACE, vol. 53, no. 10, 1 octobre 2001
(2001-10-01), pages 949-958, XP055017599, ISSN:
1343-8832**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**EP 2 541 268 B1**

**Description**

## DOMAINE TECHNIQUE

La présente invention concerne le domaine des magnétomètres vectoriels et plus particulièrement ceux à pompage optique.

## ÉTAT DE LA TECHNIQUE ANTÉRIEURE

Les magnétomètres scalaires à pompage optique sont connus depuis plusieurs décennies. Ils sont basés sur la résonance magnétique entre raies Zeeman, amplifiée à l'aide d'un pompage optique. Par exemple dans un magnétomètre de ce type utilisant une cellule d'hélium ($^4$He) les atomes d' hélium au niveau $1^1S_0$ sont excités au niveau métastable $2^3S_1$ au moyen d'une décharge HF. Ce niveau métastable $2^3S_1$ est divisé en un triplet Zeeman en présence d'un champ magnétique statique. Les atomes du niveau $2^3S_1$ sont pompés optiquement vers le niveau $2^3P_0$ à l'aide d'un laser accordable. Il en résulte une déplétion différente des différentes raies du triplet, par excitation sélective au niveau $2^3P_0$. Les atomes ainsi excités retournent par émission spontanée au niveau métastable $2^3S_1$. On induit une résonance magnétique entre les niveaux du triplet au moyen d'un champ RF à la fréquence de Larmor. L'amplitude du signal de résonance est amplifiée par le pompage optique. La résonance est observée au moyen d'un pic d'absorption en sortie de la cellule. En pratique, le générateur du champ RF est asservi en fréquence sur le pic d'absorption au moyen d'une boucle PLL, et le module du champ magnétique (d'où le terme de magnétomètre scalaire) se déduit directement de la fréquence de résonance $F$ à partir de la relation de Larmor $B_0 = F/\gamma$ où $\gamma$ est le rapport gyromagnétique de l'électron.

On trouvera une description détaillée d'un magnétomètre scalaire à pompage optique dans la demande FR-A-2 663 430 ou encore dans la demande FR-A-2 713 347.

Plus récemment sont apparus des magnétomètres vectoriels, c'est-à-dire des dispositifs permettant la mesure de composantes du champ magnétique selon plusieurs axes.

Un exemple de magnétomètre vectoriel est décrit dans la demande européenne EP-A-964260. Ce magnétomètre comprend outre un magnétomètre scalaire du type précité, trois enroulements conducteurs entourant la cellule et dont les axes forment un trièdre trirectangle. Chaque enroulement est excité avec un signal de fréquence distincte, soit $F_x$ pour l'axe Ox, $F_y$ selon l'axe Oy et $F_t$ selon l'axe Oz. L'application d'un champ magnétique le long de l'axe Ox à la fréquence $F_x$ modifie le module $B_0$ du champ à mesurer, $\mathbf{B_0}$, d'une quantité variant à fréquence $F_X$. Le signal de sortie du magnétomètre scalaire, qui donne le module du champ, comprend une composante à la fréquence $F_x$ dont l'amplitude dépend de la projection du champ $\mathbf{B_0}$ sur l'axe Ox. Une démodulation synchrone du signal d'intensité lumineuse ayant traversé le détecteur permet ainsi d'accéder à cette composante. Il en va de même pour les autres axes Oy et Oz. On trouvera une présentation détaillée du principe de la mesure dans l'article de O. Gavrand et al. intitulé « On the calibration of a vectorial 4He pumped magnetometer » publié dans Earth Planet Space, 53, pp. 949-958, 2011.

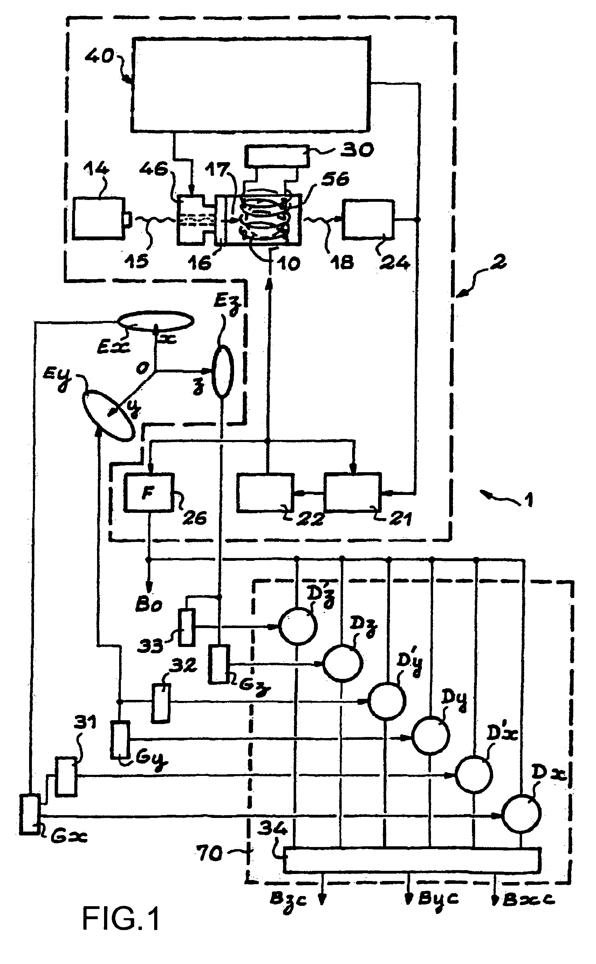

La structure du magnétomètre vectoriel précité est rappelée en Fig. 1.

Comme mentionné précédemment, il comporte un magnétomètre scalaire, délimité par le trait discontinu 2.

Le magnétomètre scalaire comprend une cellule 10 remplie d'hélium, un laser 14 émettant un faisceau à une longueur d'onde accordée à la différence d'énergie entre les niveaux $2^3P_0$ et $2^3S_1$ de $^4$He, un polariseur 16, délivrant un faisceau polarisé rectilignement 17, un photodétecteur 24 recevant le faisceau 18 ayant traversé la cellule, un circuit d'asservissement de fréquence 21 contrôlant un générateur de fréquence RF 22, un estimateur de fréquence 26 et un circuit de décharge HF 30.

Le circuit de décharge 30 fait passer les atomes d'hélium du niveau fondamental $1^1S_0$ au niveau métastable $2^3S_1$ au moyen d'une décharge électrostatique haute fréquence entre deux électrodes placées dans la cellule. Le générateur de fréquence RF alimente en courant une bobine 56 entourant ou placée à proximité de la cellule 10 de manière à engendrer un champ radiofréquence au sein de cette dernière. Ce champ RF induit une résonance magnétique entre les niveaux du triplet Zeeman. La bobine 56 et le polariseur 16 sont solidarisés mécaniquement, par exemple à l'aide d'un contact tournant, de manière à ce que toute rotation appliquée au polariseur entraîne une rotation de même angle de la direction du champ RF. La bobine 56 et le polariseur sont en outre montés de sorte que le champ RF soit aligné dans la direction de la polarisation.

Un circuit d'asservissement 40 contrôle le moteur 46 réglant la position angulaire du polariseur 16 et donc du champ RF. Plus précisément, le circuit d'asservissement 40 contrôle la direction de polarisation, de manière à obtenir une amplitude maximale du signal de résonance.

En sus du magnétomètre scalaire 2, le magnétomètre vectoriel comprend trois enroulements conducteurs Ex, Ey, Ez, orientés respectivement selon trois axes Ox, Oy, Oz de directions sensiblement orthogonales. Ces enroulements alimentés par trois générateurs Gx, Gy, Gz, chacun réglé sur une fréquence propre, soit $F_x$, $F_y$ et $F_z$, respectivement. Ces enroulements ont été représentés de manière déportée pour des raisons de visibilité mais en pratique ils sont situés autour de la cellule.

Un circuit 70 effectue un traitement du signal délivré par l'estimateur de fréquence 26, généralement, un signal fournissant le module $B_0$ du champ à mesurer.

La sortie de l'estimateur de fréquence 26 fait l'objet d'une démodulation en phase et en quadrature à chacune des fréquences $F_x$, $F_y$ et $F_z$. Les démodulateurs en phase sont notés Dx, Dy, Dz alors que les démodulateurs en quadrature sont notés D' x, D' y, D' z. Ces dernières reçoivent les signaux de modulation déphasés à l'aide des retards quart d'onde 31, 32, 33 ou des moyens de déphasage équivalents.

Les composantes en phase et en quadrature, à chacune des fréquences $F_x$, $F_y$ et $F_z$ sont fournies au module de calcul 34 qui en déduit les composantes de $B_0$ selon les axes Ox, Oy et Oz.

Le magnétomètre vectoriel illustré en Fig. 1 donne de bons résultats mais présente toutefois des performances en résolution et en précision bien inférieures aux performances intrinsèques du magnétomètre scalaire qu'il utilise.

On rappelle tout d'abord que la résolution d'un magnétomètre est la plus petite variation de champ magnétique qu'il peut détecter alors que sa précision est l'écart type des valeurs mesurées par rapport à la valeur réelle du champ magnétique. L'erreur de précision possède une composante de justesse et une composante de fidélité.

Ces limitations en résolution et précision sont essentiellement dues au fait que les amplitudes de modulation du champ magnétique selon les axes Ox, Oy, Oz, dénommées ci-après amplitudes de modulation vectorielle, ne peuvent être choisies trop élevées sous peine de nuire à la linéarité du capteur et d'introduire une distorsion de mesure. En outre, les amplitudes de modulation vectorielle et les fréquences de modulation doivent être choisies suffisamment faibles pour respecter les conditions d'excitation adiabatique. On dit que l'excitation est adiabatique lorsque le signal RF de résonance « voit » le champ magnétique efficace (champ ambiant plus composante modulée) comme un champ statique, autrement dit lorsque les variations de champ sont suffisamment lentes par rapport à la largeur fréquentielle du pic de résonance.

En pratique pour un champ ambiant à mesurer de l'ordre de 50 $\mu$T (intensité du champ magnétique terrestre), les amplitudes de modulation vectorielle ne peuvent guère dépasser 50 nT pour une fréquence de modulation de l'ordre d'une dizaine de Hertz. De ce fait, la résolution pour chacune des composantes du champ est également de l'ordre de 50 nT alors que celle du magnétomètre scalaire est de l'ordre d'une dizaine de pT. La résolution du magnétomètre vectoriel est donc dégradée de 3 ordres de grandeur par rapport à celle du magnétomètre scalaire correspondant. En outre, dans les mêmes conditions de mesure, et une précision sur les amplitudes de modulation vectorielles de l'ordre de 1 pT, la précision du magnétomètre vectoriel ne peut descendre en deçà de 1 nT.

Le but de la présente invention est par conséquent de proposer un magnétomètre vectoriel de résolution et de précision améliorées.

## EXPOSÉ DE L'INVENTION

La présente invention est définie par le dispositif de mesure des composantes d'un champ magnétique ambiant de la revendication 1. Les revendications dépendantes définissent des modes de réalisation avantageux.

L'invention concerne également un procédé de mesure des composantes d'un champ magnétique ambiant tel que défini par la revendication 9 au moyen du dispositif de mesure de la revendication 1.

L'invention concerne enfin une autre variante du procédé de mesure des composantes d'un champ magnétique ambiant tel que defini par la revendication 10 au moyen du dispositif de la revendication 1.

## BRÈVE DESCRIPTION DES DESSINS

La Fig. 1 représente un magnétomètre vectoriel connu de l'état de la technique ;
La Fig. 2 représente de manière schématique un magnétomètre vectoriel selon un mode de réalisation de l'invention ;
La Fig. 3 représente de manière schématique un procédé de mesure des composantes du champ magnétique ambiant au moyen du magnétomètre de la Fig. 2, selon une première variante de l'invention ;
La Fig. 4 représente de manière schématique un procédé de mesure des composantes du champ magnétique ambiant au moyen du magnétomètre de la Fig. 2, selon une seconde variante de l'invention.

## EXPOSÉ DÉTAILLÉ DE MODES DE RÉALISATION PARTICULIERS

Le principe de base de l'invention est de superposer au champ magnétique ambiant à mesurer un champ modulé orthogonal à ce dernier. Cette configuration permet des amplitudes de modulation vectorielle sensiblement plus élevées que dans l'état de la technique sans pour autant affecter la linéarité de la mesure car le module du champ efficace ne varie alors que faiblement.

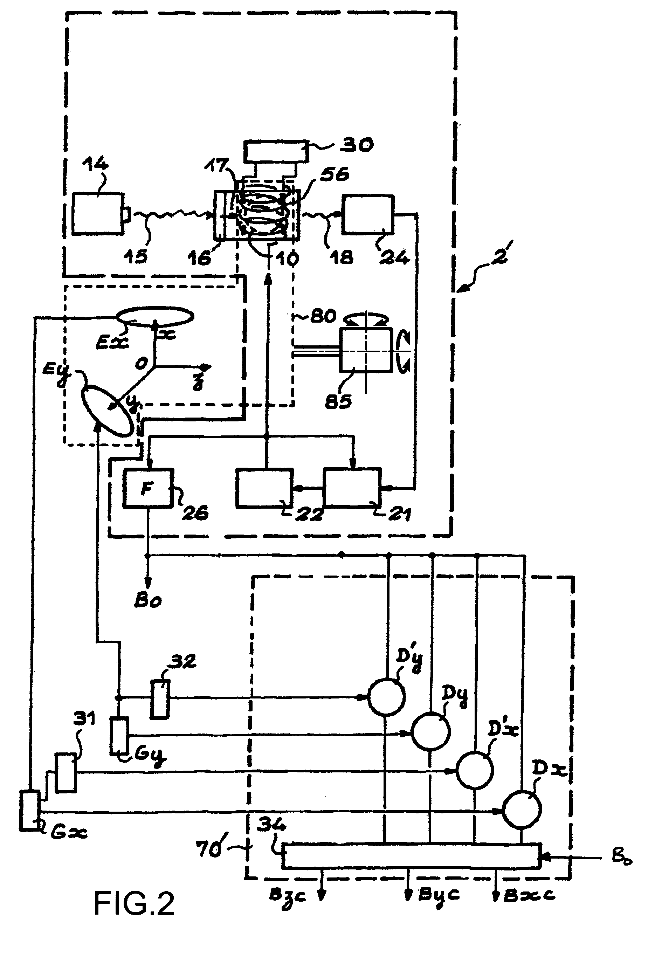

La Fig. 2 représente un magnétomètre vectoriel selon un mode de réalisation de l'invention.

Ce magnétomètre est basé comme précédemment sur un magnétomètre scalaire à pompage optique, 2'. Les éléments portant les mêmes numéros de référence qu'en Fig. 1 sont identiques ou similaires.

Le magnétomètre scalaire 2' comporte comme précédemment un laser accordable 14, un polariseur 16, une cellule 10 remplie de gaz, par exemple d'hélium, un photodétecteur 24 recevant le faisceau laser polarisé ayant traversé la cellule 10, un circuit de décharge 30 faisant passer les atomes de gaz à un niveau excité (dans le cas de l'hélium au niveau métastable $2^3S_1$) au moyen d'une décharge électrostatique haute fréquence, un circuit d'asservissement de fréquence 21 recevant le signal électrique du photodétecteur et pilotant la fréquence du générateur RF 22 alimentant la bobine. L'asservissement est réalisé sur le pic d'absorption de la cellule et la fréquence correspondante est la fréquence de Larmor associée au champ magnétique dans lequel elle est située.

La structure du magnétomètre scalaire 2' est toutefois plus simple que celle du magnétomètre scalaire 2. En effet, celui-ci ne possède pas de moteur 46 faisant varier la polarisation du faisceau laser à l'entrée de la cellule 10, et par conséquent pas de circuit d'asservissement 40.

Le polariseur 16 est fixe par rapport à la bobine 56 et délivre un faisceau polarisé rectiligne ayant pour direction de polarisation l'axe de celle-ci. Autrement dit, le champ RF excitant les atomes de gaz coïncide avec la direction de polarisation du faisceau laser incident.

Le magnétomètre scalaire 2' fournit un signal représentatif du module du champ magnétique dans lequel se situe la cellule (par exemple la fréquence de Larmor correspondante).

A la différence de la Fig. 1, le magnétomètre vectoriel ne comporte ici que deux enroulements conducteurs Ex et Ey destinés à moduler le champ magnétique appliqué à la cellule.

Les axes Ox, Oy des deux enroulements conducteurs Ex et Ey sont distincts et choisis orthogonaux. L'axe de la bobine 56 (par conséquent la direction du champ RF) et les axes Ox, Oy sont situés dans un même plan.

Les générateurs Gx et Gy alimentent les enroulements conducteurs Ex et Ey avec des signaux périodiques, typiquement des signaux sinusoïdaux, de fréquences *distinctes* $F_x$ et $F_y$, dénommés ci-après signaux de modulation vectorielle. Comme précédemment, ces signaux sont également utilisés pour effectuer une démodulation en phase et en quadrature du signal de mesure issu du magnétomètre scalaire. Le module de calcul 34 du circuit de traitement 70' reçoit les composantes en phase et en quadrature démodulées aux fréquences $F_x$ et $F_y$. Dans une étape précédente, le module de calcul 34 a préalablement stocké en mémoire le module du champ ambiant $B_0$ comme expliqué plus loin.

Les composantes $B_x$ et $B_y$ sont obtenues à partir des composantes spectrales de l'intensité du champ, aux *fréquences $F_x$* et $F_y$ comme dans l'art antérieur. En revanche, la troisième composante est déduite de la relation :

$$\left| B_z \right| = \left( B_0^2 - B_x^2 - B_y^2 \right)^{1/2} \qquad (1)$$

La bobine 56 et les enroulements Ex et Ey forment un ensemble 80, solidaire mécaniquement d'un support orientable 85. Ce support est monté sur des moyens d'orientation (non représentés), mécaniques ou électromécaniques, pour orienter et maintenir les axes des enroulements conducteurs Ex et Ey, ainsi que la direction du champ RF, dans un plan sensiblement orthogonal au champ magnétique ambiant.

Selon un exemple des réalisation, les moyens d'orientation peuvent être un goniomètre amagnétique. Ce dispositif ne génère ni ne perturbe le champ magnétique ambiant. Il fournit l'orientation angulaire du champ magnétique et permet d'orienter le support dans la direction de ce dernier.

Les moyens d'orientation peuvent être pilotés par un signal de contrôle, extérieur ou non au magnétomètre vectoriel, indiquant la direction du champ magnétique ambiant. Par exemple, ce signal de contrôle peut être fourni par un magnétomètre angulaire. Alternativement, ce signal de contrôle peut être généré par le magnétomètre vectoriel lui-même, lors d'une phase de calibration grossière, comme expliqué plus loin.

Dans tous les cas, l'orientation du support dans la direction du champ magnétique peut être réalisée avec une précision relativement grossière, de 1% à 0,1%, de préférence égale à 0.1%. Il est important de comprendre que cette orientation a pour but de se placer dans des conditions de mesure à faible niveau de distorsion, et non de connaître précisément l'orientation du champ magnétique ambiant. L'orientation précise de ce dernier est, quant à elle, donnée par la mesure des composantes du champ ambiant.

Le champ magnétique efficace, c'est-à-dire effectivement appliqué à la cellule, peut être représenté par :

$$\mathbf{B}_{\text{eff}} = \mathbf{B}_0 + \mathbf{bm}_x e^{j2\pi F_x t} + \mathbf{bm}_y e^{j2\pi F_y t} \qquad (2)$$

où $\mathbf{B_0}$ est le vecteur magnétique du champ ambiant, $\mathbf{bm}_x e^{j2\pi F_x t}$ et $\mathbf{bm}_y e^{j2\pi F_y t}$ les champs magnétiques respectivement engendrés par les enroulements conducteurs Ex et Ey . Les vecteurs $\mathbf{bm_x}$ et $\mathbf{bm}_y$ sont sensiblement orthogonaux à $\mathbf{B}_0$

de sorte que l'extrémité du vecteur **B**_eff parcourt une ellipse dans le plan Oxy. On choisira en outre avantageusement $bm_x = bm_y$ pour minimiser la distorsion. Les amplitudes $bm_x = \|\mathbf{bm}_x\|$ et $bm_y = \|\mathbf{bm}\|$ sont choisies avantageusement d'un à deux ordres de grandeur plus faibles que l'amplitude du champ ambiant $B_0$ (pour des fréquence de modulation de quelques Hz à 20Hz), soit à des niveaux 10 à 100 fois supérieurs utilisés dans l'art antérieur. L'intensité $B_{eff}$ du champ efficace ne variant que faiblement dans le temps, le magnétomètre reste en régime linéaire et l'on peut atteindre une résolution et une précision de la mesure des composantes vectorielles du champ, de 10 à 100 fois meilleures que celles de l'art antérieur.

On choisit en outre les produits $bm_x F_x$ et $bm_y F_y$ suffisamment faibles (inférieurs à $10^{-5}$ voire à $10^{-6}$ T.Hz) pour rester en régime d'excitation adiabatique. Pour des fréquences de modulation inférieures à 20 Hz, le respect de ce critère se traduit par une borne supérieure des amplitudes $bm_x$ et $bm_y$ de l'ordre du millième de l'intensité du champ ambiant. Par exemple, on pourra prendre pour la mesure du champ magnétique terrestre $bm_x = bm_y = 1nT$, $F_x = 20Hz$ et $F_y = 9Hz$.

La mesure des composantes $bm_x$ et $bm_y$ peut être utilisée dans une phase grossière de calibration aux fins de l'orientation du support. Dans un tel cas, un signal de contrôle est généré de sorte à minimiser $b_\perp = \left( B_x^2 + B_y^2 \right)^{1/2}$, c'est-à-dire à orienter les axes Ox et Oy orthogonalement au champ ambiant.

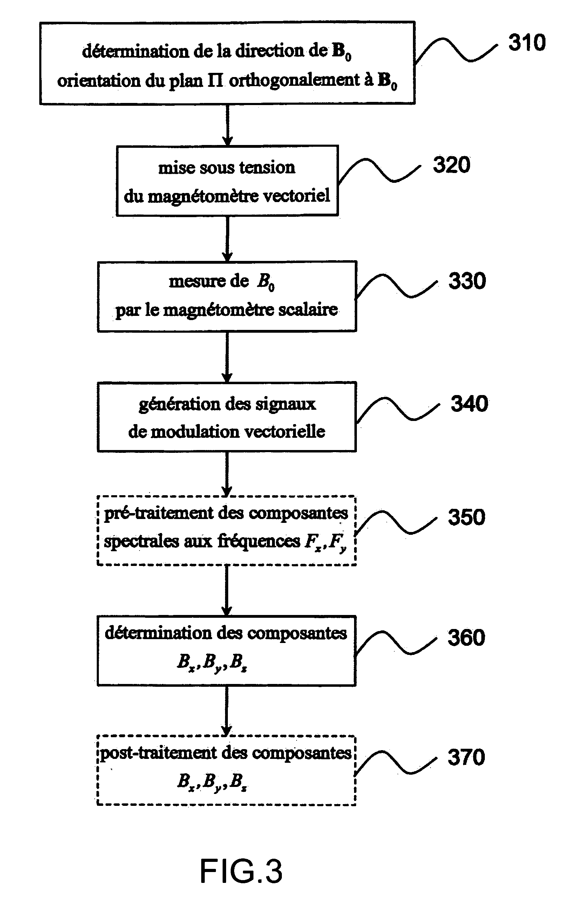

La Fig. 3 représente de manière schématique un procédé de mesure des composantes du champ magnétique ambiant au moyen du magnétomètre vectoriel de la Fig. 2, selon une première variante de l'invention.

Dans une première étape 310, avant de mettre sous tension le magnétomètre vectoriel pour éviter toute perturbation électromagnétique, on détermine à l'aide du goniomètre amagnétique la direction du champ magnétique ambiant **B**_0 et on oriente le support 85 de sorte que le plan Π contenant l'axe de la bobine 56 et les axes Ox, Oy des deux enroulements conducteurs soit orthogonal au champ magnétique ambiant.

Après avoir mis sous tension le magnétomètre vectoriel en 320, mais en absence de génération de signaux de modulation vectorielle, le module $B_0$ du champ magnétique ambiant est mesuré en 330 par le magnétomètre scalaire 2' et stocké dans les moyens de calcul 34 pour une utilisation ultérieure.

A l'étape 340, les générateurs Gx et Gy sont activés et injectent les signaux de modulation vectorielle dans les enroulements conducteurs Ex et Ey respectivement.

A l'étape 360, on détermine les composantes $B_x$, $B_y$ du champ ambiant à partir des composantes spectrales de $B_{eff}$ aux fréquences $F_x$ et $F_y$ et l'on en déduit la composante $B_z$ grâce à la relation (1) à partir du module $B_0$ obtenu à l'étape 330.

Alternativement, selon une variante non représentée, la mesure de $B_0$ n'est pas effectuée lors d'une étape distincte 330, préalablement à la génération des signaux de modulation vectorielle, mais simultanément à la détermination des composantes $B_x$, $B_y$ à l'étape 360. Selon cette variante, le module $B_0$ est obtenu par la composante DC du signal représentatif de $B_{eff}$, fourni par l'estimateur de fréquence 26. Le module $B_0$ est donc donné par la composante spectrale de $B_{eff}$ à la fréquence nulle.

Quelle que soit la variante, divers prétraitements ou post-traitements peuvent être envisagés dans les moyens de calcul.

Par exemple, les moyens de calcul peuvent optionnellement corriger à l'étape 350 les composantes spectrales pour tenir compte de l'évolution de la fonction de transfert du magnétomètre scalaire en fonction de la fréquence, comme expliqué dans le brevet EP-B-1 344 075. Les composantes spectrales de $B_{eff}$ sont alors compensées de la variation de la fonction de transfert préalablement à l'obtention des composantes $B_x$, $B_y$, la composante $B_z$ se déduisant de la relation (1) comme précédemment.

En outre, lorsque le module $B_0$ est obtenu au moyen de la composante spectrale DC de $B_{eff}$, celle-ci peut être avantageusement corrigée de manière à compenser le battement des composantes aux fréquences $F_x, F_y$ avec elles-mêmes. En effet, ce battement induit une composante parasite à la fréquence nulle, d'intensité sensiblement égale à $b_m^2 / 2B_0$. Le module $B_0$ est alors estimé non plus comme $B_{eff}(0)$ mais est corrigé comme suit :

$$ B_0 = B_{eff}(0) - \left( B_x^2 + B_y^2 \right) / 2B_{eff}(0) \qquad (3) $$

où $B_{eff}(0)$ est la composante DC du spectre de $B_{eff}$.

Optionnellement, en 370, une transformation des composantes $B_x$, $B_y$, $B_z$ peut être prévue pour obtenir des composantes dans un repère orthonormé du magnétomètre, non lié au support. D'autres traitements utilisant une calibration, un filtrage de mesures successives pour améliorer le rapport signal sur bruit, peuvent être également envisagés sans pour autant sortir du cadre de la présente invention.

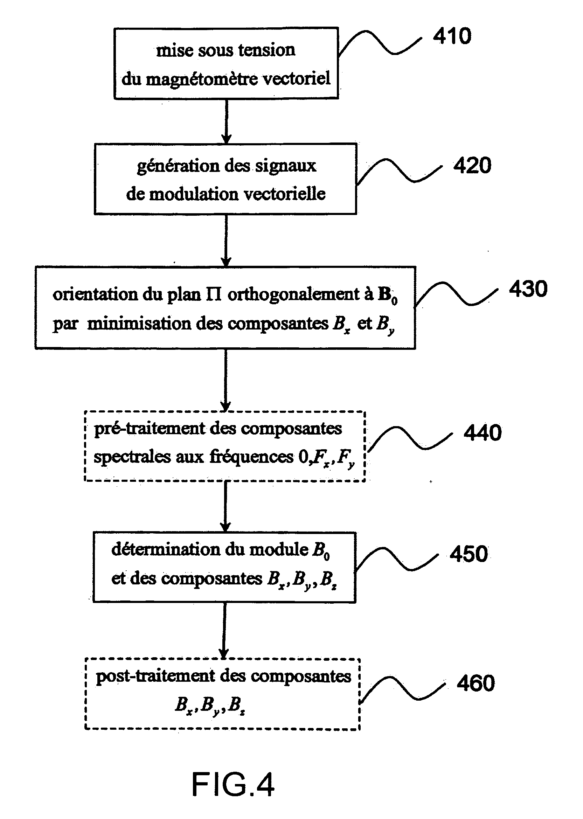

La Fig. 4 représente de manière schématique un procédé de mesure des composantes du champ magnétique ambiant au moyen du magnétomètre vectoriel de la Fig. 2, selon une seconde variante de l'invention.

Après que le magnétomètre vectoriel ait été mis sous tension en 410, les signaux de modulation vectorielle sont générés par Gx et Gy et injectés dans les enroulements conducteurs Ex et Ey, en 420.

Le support 85 est orienté en 430, de manière à minimiser les *composantes $B_x$ et $B_y$* ou, de manière équivalente, la composante transversale $B\perp$.

Les composantes DC et aux fréquences $F_x, F_y$ font optionnellement l'objet d'un prétraitement à l'étape 440. Le prétraitement de la composante DC peut être la correction exprimée par la relation (3). Les composantes aux fréquences $F_x, F_y$ peuvent subir le même traitement que celui de l'étape 350 déjà décrite.

On procède en 450 à la détermination du module $B_0$ et des composantes $B_x, B_y$ à partir des composantes spectrales aux fréquence 0, $F_x, F_y$, respectivement, préalablement corrigées en 440 ou non, et l'on déduit la composante $B_z$ de la relation(1) ;

Enfin, on procède optionnellement à un post-traitement des composantes $B_x$, $B_y$, $B_z$ comme décrit en relation avec l'étape 370.

## Revendications

1. Dispositif de mesure des composantes d'un champ magnétique ambiant comportant :

   - un magnétomètre scalaire à pompage optique comprenant une cellule (10) remplie d'un gaz, une source laser (14) émettant un faisceau lumineux, un polariseur (16) polarisant rectilignement ledit faisceau selon une direction de polarisation, un photodétecteur recevant le faisceau polarisé ayant traversé la cellule et fournissant un signal électrique, une bobine (56) entourant la cellule, alimentée par un générateur radiofréquence (22) et dont l'axe coïncide avec ladite direction de polarisation, des moyens d'asservissement en fréquence recevant ledit signal électrique et asservissant la fréquence du générateur radiofréquence à la fréquence de Larmor, un estimateur de fréquence estimant la fréquence du signal radiofréquence générée par ledit générateur, le magnétomètre scalaire fournissant un signal représentatif du module du champ magnétique dans lequel est située la cellule à partir de la fréquence ainsi estimée ;
   - deux enroulements conducteurs (Ex, Ey), d'axes (Ox, Oy) orthogonaux, disposés autour de la cellule, respectivement alimentés par deux générateurs (Gx, Gy) de fréquences ($F_x$, $F_y$) distinctes, des moyens de démodulation (Dx,D'x; Dy,D'y) adaptés à démoduler le signal fourni par le magnétomètre scalaire en phase et en quadrature aux deux fréquences distinctes et à fournir les composantes spectrales de ce signal à ces deux fréquences, des moyens de calcul (34) déterminant à partir desdites composantes spectrales et du module champ magnétique ambiant, les composantes selon trois axes orthogonaux (Ox,Oy,Oz) du champ magnétique ambiant ;

   **caractérisé en ce que** :

   - les deux enroulements conducteurs (Ex,Ey) et la bobine sont solidaires mécaniquement d'un support orientable (85), les axes des deux enroulements conducteurs et de la bobine étant situés dans un même plan ;
   - ledit support (85) est monté sur des moyens d'orientation mécaniques ou électromécaniques, de manière à pouvoir orienter ledit plan sensiblement orthogonalement à la direction du champ magnétique ambiant.

2. Dispositif de mesure selon la revendication 1, **caractérisé en ce que** les moyens d'orientation comprennent un goniomètre amagnétique.

3. Dispositif de mesure selon la revendication 1, **caractérisé en ce que** les moyens d'orientation sont adaptés à recevoir un signal de contrôle fonction de l'intensité des composantes dudit champ magnétique selon les axes des deux enroulements conducteurs.

4. Dispositif de mesure selon l'une quelconque des revendications précédentes, **caractérisé en ce que** les fréquences distinctes $F_x$, $F_y$ et les amplitudes $bm_x, bm_y$ des signaux générés par lesdits deux générateurs sont choisies de sorte à ce que les produits $bm_x F_x$ et $bm_y F_y$ remplissent les conditions d'excitation adiabatique.

5. Dispositif de mesure selon la revendication 1, **caractérisé en ce que** les moyens de calcul sont adaptés à déterminer les *composantes $B_x$* et *By* du champ magnétique ambiant sur les deux axes (Ox,Oy) des enroulements conducteurs et à en déduire la composante selon un axe (Oz) orthogonal aux deux axes précédents au moyen de la relation

$$\left| B_z \right| = \left( B_0^2 - B_x^2 - B_y^2 \right)^{1/2}$$ où $B_0$ est le module du champ magnétique ambiant mesuré.

6. Dispositif de mesure selon la revendication 5, **caractérisé en ce que** le magnétomètre scalaire en absence d'alimentation des deux enroulements conducteurs est adapté à fournir aux moyens de calcul (34) le module du champ magnétique ambiant.

7. Dispositif de mesure selon la revendication 5, **caractérisé en ce que** les moyens de calcul sont adaptés à calculer le module du champ magnétique ambiant à partir de la composante spectrale à la fréquence nulle du signal fourni par le magnétomètre scalaire.

8. Dispositif de mesure selon la revendication 7, **caractérisé en ce que** les moyens de calcul sont adaptés à corriger préalablement la composante spectrale à la fréquence nulle, $B_{eff}(0)$, d'un offset égal à $\left( B_x^2 + B_y^2 \right) / 2 B_{eff}(0)$ .

9. Procédé de mesure des composantes d'un champ magnétique ambiant au moyen du dispositif de mesure de la revendication 1, **caractérisé en ce que** :

   a) on détermine (310) la direction du champ magnétique ambiant, avant de mettre sous tension ledit dispositif, et on oriente ledit support (85) de manière à ce que le plan contenant les axes des enroulements conducteurs et l'axe de la bobine soit sensiblement orthogonal à la direction du champ magnétique ambiant ;
   b) on procède à la mesure (330) du champ magnétique ambiant au moyen du magnétomètre scalaire, après avoir mis sous tension ledit dispositif ;
   c) on alimente (340) les deux enroulements conducteurs par les générateurs de fréquences distinctes ($F_x, F_y$);
   d) les moyens de calcul déterminent (360) les composantes du champ magnétique ambiant selon les axes des deux enroulements conducteurs à partir des composantes spectrales, aux deux fréquences distinctes, du signal fourni par le magnétomètre scalaire à l'étape c) et en déduisent la composante orthogonale à ces deux axes à partir du module du champ magnétique ambiant obtenu à l'étape b).

10. Procédé de mesure des composantes d'un champ magnétique ambiant au moyen du dispositif de mesure de la revendication 1, **caractérisé en ce que** :

    a) on alimente (420) les deux enroulements conducteurs par les générateurs de fréquences distinctes ($F_x, F_y$), après avoir mis ledit dispositif sous tension ;
    b) on oriente le plan (Π) contenant les deux axes des enroulements conducteurs et l'axe de la bobine, sensiblement orthogonalement à la direction du champ magnétique ambiant en minimisant les amplitudes des composantes du champ magnétique mesuré selon ces deux axes ;
    c) les moyens de calcul déterminent (450) le module du champ magnétique ambiant à partir de la composante de fréquence nulle du signal fourni par le magnétomètre scalaire ;
    d) les moyens de calcul déterminent (450) les composantes du champ magnétique ambiant selon les axes des deux enroulements conducteurs à partir des composantes spectrales, aux deux fréquences distinctes, du signal fourni par le magnétomètre scalaire et en déduisent la composante orthogonale à ces deux axes à partir du module du champ magnétique ambiant obtenu à l'étape c).

11. Procédé de mesure selon la revendication 10, **caractérisé en ce que** la composante spectrale à la fréquence nulle, $B_{eff}(0)$, est préalablement corrigée d'un offset égal à $\left( B_x^2 + B_y^2 \right) / 2 B_{eff}(0)$ , *où $B_x$ et $B_y$ sont les composantes du champ magnétique ambiant selon les axes des deux enroulements conducteurs.*

12. Procédé de mesure selon l'une quelconque des revendication 9 à 11, **caractérisé en ce que** les moyens de calcul déterminent une variation de la fonction de transfert du magnétomètre scalaire en fonction de la fréquence, corrigent (350, 440) lesdites composantes spectrales, aux deux fréquences distinctes, pour compenser cette variation, les composantes du champ magnétique ambiant étant alors déterminées (360, 450) à partir des composantes spectrales ainsi corrigées.

**Patentansprüche**

1. Vorrichtung zum Messen der Komponenten eines umgebenden Magnetfelds, umfassend:

   - ein skalares Magnetometer zum optischen Pumpen, umfassend eine mit einem Gas gefüllte Zelle (10), eine Laserquelle (14), die einen Lichtstrahl emittiert, einen Polarisator (16), der den Strahl linear in einer Polarisationsrichtung polarisiert, einen Fotodetektor, der den polarisierten Strahl empfängt, der die Zelle durchquert hat, und ein elektrisches Signal liefert, eine die Zelle umgebende Spule (56), die von einem Radiofrequenzgenerator (22) versorgt wird und deren Achse mit der Polarisationsrichtung zusammenfällt, Frequenzregelungsmittel, die das elektrische Signal empfangen und die Frequenz des Radiofrequenzgenerators auf die Larmorfrequenz regeln, einen Frequenzabschätzer, der die durch den Generator generierte Frequenz des Radiofrequenzsignals abschätzt, wobei das skalare Magnetometer ausgehend von der derart abgeschätzten Frequenz ein Signal liefert, das repräsentativ ist für den Betrag des Magnetfelds, in dem sich die Zelle befindet;
   - zwei leitende Wicklungen (Ex, Ey) mit orthogonalen Achsen (Ox, Oy), die um die Zelle herum angeordnet und von zwei jeweiligen Generatoren (Gx, Gy) mit unterschiedlichen Frequenzen ($F_x$, $F_y$) versorgt sind, Demodulationsmittel (Dx, D'x; Dy, D'y), die ausgelegt sind für eine Phasen- und Quadraturdemodulation des vom skalaren Magnetometer gelieferten Signals mit den zwei unterschiedlichen Frequenzen und zum Liefern der spektralen Komponenten dieses Signals mit diesen zwei Frequenzen, wobei Rechenmittel (34) ausgehend von den spektralen Komponenten und von dem Betrag des umgebenden Magnetfelds die Komponenten des umgebenden Magnetfelds entlang drei orthogonalen Achsen (Ox, Oy, Oz) bestimmen;
   dadurch gekennzeichet, dass:

   - die zwei leitenden Wicklungen (Ex, Ey) und die Spule mechanisch mit einem orientierbaren Träger (85) verbunden sind, wobei die Achsen der zwei leitenden Wicklungen und die Spule in ein und derselben Ebene angeordnet sind;
   - der Träger (85) auf mechanischen oder elektromechanischen Orientierungsmitteln derart montiert ist, dass er in der Ebene im Wesentlichen orthogonal zur Richtung des umgebenden Magnetfelds orientiert werden kann.

2. Messvorrichtung nach Anspruch 1, **dadurch gekennzeichnet, dass** die Orientierungsmittel ein unmagnetisches Goniometer umfassen.

3. Messvorrichtung nach Anspruch 1, **dadurch gekennzeichnet, dass** die Orientierungsmittel dazu ausgelegt sind, ein Kontrollsignal zu empfangen, das eine Funktion der Intensität der Komponenten des Magnetfelds entlang den Achsen der zwei leitenden Wicklungen ist.

4. Messvorrichtung nach einem der vorhergehenden Ansprüche, **dadurch gekennzeichnet, dass** die unterschiedlichen Frequenzen ($F_x$, $F_y$) und die Amplituden ($bm_x$, $bm_y$) der von den zwei Generatoren generierten Signale derart gewählt sind, dass die Produkte $bm_x F_x$ und $bm_y F_y$ die adiabatischen Anregungsbedingungen erfüllen.

5. Messvorrichtung nach Anspruch 1, **dadurch gekennzeichnet, dass** die Rechenmittel dazu ausgelegt sind, die Komponenten $B_x$ und $B_y$ des umgebenden Magnetfelds auf den zwei Achsen (Ox, Oy) der leitenden Wicklungen zu bestimmen und hieraus die Komponente entlang einer Achse (Oz) orthogonal zu den vorstehenden zwei Achsen mit Hilfe der Relation $|B_Z| = \left( B_0^2 - B_x^2 - B_y^2 \right)^{1/2}$ herzuleiten, wobei $B_0$ der Betrag des gemessenen umgebenden Magnetfelds ist.

6. Messvorrichtung nach Anspruch 5, **dadurch gekennzeichnet, dass** das skalare Magnetometer in Abwesenheit einer Versorgung der zwei leitenden Wicklungen dazu ausgelegt ist, an die Rechenmittel (34) den Betrag des umgebenden Magnetfelds zu liefern.

7. Messvorrichtung nach Anspruch 5, **dadurch gekennzeichnet, dass** die Rechenmittel dazu ausgelegt sind, den Betrag des umgebenden Magnetfelds ausgehend von der spektralen Komponente des vom skalaren Magnetometer gelieferten Signals bei der Frequenz Null zu berechnen.

8. Messvorrichtung nach Anspruch 7, **dadurch gekennzeichnet, dass** die Rechenmittel dazu ausgelegt sind, zuvor die spektrale Komponente bei der Frequenz Null, $B_{eff}$ (0) um einen Offset gleich $\left( B_x^2 + B_y^2 \right) / 2 B_{eff}$ (0) zu korrigieren.

**9.** Verfahren zum Messen der Komponenten eines umgebenden Magnetfelds mit Hilfe der Messvorrichtung nach Anspruch 1, **dadurch gekennzeichnet, dass**:

a) man die Richtung des umgebenden Magnetfelds bestimmt (310), bevor man die Vorrichtung unter Spannung setzt, und man den Träger (85) derart orientiert, dass die Ebene, die die Achsen der leitenden Wicklungen sowie die Achse der Spule enthält, im Wesentlichen orthogonal zur Richtung des umgebenden Magnetfelds ist;
b) man zur Messung (330) des umgebenden Magnetfelds mit Hilfe des skalaren Magnetometers übergeht, nachdem man die Vorrichtung unter Spannung gesetzt hat;
c) man die zwei leitenden Wicklungen durch die Generatoren mit unterschiedlichen Frequenzen ($F_x$, $F_y$) versorgt (340);
d) die Rechenmittel die Komponenten des umgebenden Magnetfelds entlang den Achsen der zwei leitenden Wicklungen ausgehend von den spektralen Komponenten bei den zwei verschiedenen Frequenzen des Signals bestimmen (360), das im Schritt c) von dem skalaren Magnetometer geliefert wird, und hieraus die Komponente orthogonal zu diesen beiden Achsen ausgehend von dem im Schritt b) erhaltenen Betrag des umgebenden Magnetfelds ableiten.

**10.** Verfahren zum Messen der Komponenten eines umgebenden Magnetfelds mit Hilfe der Messvorrichtung nach Anspruch 1, **dadurch gekennzeichnet, dass**:

a) man die zwei leitenden Wicklungen durch die Generatoren mit unterschiedlichen Frequenzen ($F_x$, $F_y$) versorgt (420), nachdem man die Vorrichtung unter Spannung gesetzt hat;
b) man die Ebene (II), die die zwei Achsen der leitenden Wicklungen sowie die Achse der Spule enthält, im Wesentlichen orthogonal zur Richtung des umgebenden Magnetfelds orientiert, indem man die Amplituden der Komponenten des Magnetfelds minimiert, gemessen entlang diesen beiden Achsen;
c) die Rechenmittel den Betrag des umgebenden Magnetfelds ausgehend von der Komponente des von dem skalaren Magnetometer gelieferten Signals mit der Frequenz 0 bestimmen (450);
d) die Rechenmittel die Komponenten des umgebenden Magnetfelds entlang den Achsen der zwei leitenden Wicklungen ausgehend von den spektralen Komponenten bei den zwei verschiedenen Frequenzen des Signals bestimmen (450), das von dem skalaren Magnetometer geliefert wird, und hieraus die Komponente orthogonal zu diesen beiden Achsen ausgehend dem im Schritt c) erhaltenen Betrag des umgebenden Magnetfelds ableiten.

**11.** Messverfahren nach Anspruch 10, **dadurch gekennzeichnet, dass** die spektrale Komponente bei der Frequenz 0, $B_{eff}$ (0), zuvor um einen Offset gleich $\left( B_x^2 + B_y^2 \right) / 2 B_{eff} \left( 0 \right)$ korrigiert wird, wobei $B_x$ und $B_y$ die Komponenten des umgebenden Magnetfelds entlang den Achsen der zwei leitenden Wicklungen sind.

**12.** Messverfahren nach einem der Ansprüche 9 bis 11, **dadurch gekennzeichnet, dass** die Rechenmittel eine Variation der Transferfunktion des skalaren Magnetometers als Funktion der Frequenz bestimmen, die spektralen Komponenten mit den zwei verschiedenen Frequenzen korrigieren (350, 440), um diese Variation zu kompensieren, wobei die Komponenten des umgebenden Magnetfelds dann ausgehend von den derart korrigierten spektralen Komponenten bestimmt werden (360, 450).

**Claims**

**1.** A device for measuring the components of an ambient magnetic field including:

- an optically pumped scalar magnetometer comprising a cell (10) filled with a gas, a laser source (40) emitting a light beam, a polarizer (16) rectilinearly polarizing said beam along a direction of polarization, a photodetector receiving the polarized beam that passed through the cell and providing an electrical signal, a coil (56) surrounding the cell, powered by a radiofrequency generator (22) and the axis of which registers with said direction of polarization, frequency locking means receiving said electrical signal and locking the frequency of the radiofrequency generator to the Larmor frequency, a frequency estimator estimating the frequency of the radiofrequency signal generated by said generator, the scalar magnetometer providing a signal representative of the module of the magnetic field in which the cell is located from the frequency thus estimated;
- two conductive windings (Ex, Ey), having orthogonal axes (Ox, Oy), provided around the cell, respectively powered by two generators (Gx, Gy) having distinct frequencies ($F_x$, $F_y$), demodulation means (Dx,D'x; Dy,D'y) adapted to demodulate the signal provided by the scalar magnetometer in phase and quadrature to both distinct frequencies and to provide the spectral components of this signal at these two frequencies, calculation means (34) determining from said spectral components and from the module of the ambient magnetic field, the components along three orthogonal axes (Ox,Oy,Oz) of the ambient magnetic field;

**characterised in that**:

- both conductive windings (Ex,Ey) and the coil are mechanically integral with a swivel support (85), the axes of both conductive windings and of the coil being located in a same plane;
- said support (85) is mounted on swivel mechanical or electromechanical means, so as to be able to swivel said plane substantially orthogonally to the direction of the ambient magnetic field.

2. The measuring device according to claim 1, **characterised in that** the swivel means comprise a non-magnetic goniometer.

3. The measuring device according to claim 1, **characterised in that** the swivel means are adapted to receive a control signal depending on the intensity of the components of said magnetic field along the axes of both conductive windings.

4. The measuring device according to any of the preceding claims, **characterised in that** the distinct frequencies $F_x$, $F_y$ and the amplitudes $bm_x$, $bm_y$ of the signals generated by said two generators are selected so that the products $bm_x F_x$ and $bm_y F_y$ fulfil adiabatic excitation conditions.

5. The measuring device according to claim 5, **characterised in that** the calculation means are adapted to determine the components $B_x$ and $B_y$ of the ambient magnetic field on both axes (Ox,Oy) of the conductive windings and deduce therefrom the component along an axis (Oz) orthogonal to both preceding axes by means of the relationship

$$\left|B_z\right| = \left(B_0^2 - B_x^2 - B_y^2\right)^{1/2}$$ where $B_0$ is the module of the ambient magnetic field measured.

6. The measuring device according to claim 5, **characterised in that** the scalar magnetometer in the absence of power supply to both conductive windings is adapted to supply to the calculation means (34) the module of the ambient magnetic field.

7. The measuring device according to claim 5, **characterised in that** the calculation means are adapted to calculate the module of the ambient magnetic field from the spectral component at the zero frequency of the signal provided by the scalar magnetometer.

8. The measuring device according to claim 7, **characterised in that** the calculation means are adapted to correct the spectral component at the zero frequency, $B_{eff}(0)$, beforehand, by an offset equal to $\left(B_x^2 + B_y^2\right)/2B_{eff}(0)$.

9. A method for measuring the components of an ambient magnetic field by means of the measuring device of claim 1, **characterised in that**:

a) the direction of the ambient magnetic field is determined (310), before said device is switched on, and said support (85) is swivelled so that the plane containing the axes of the conductive windings and the axis of the coil is substantially orthogonal to the direction of the ambient magnetic field;
b) the measurement (330) of the ambient magnetic field is conducted by means of the scalar magnetometer, after said device is switched on;
c) both conductive windings are powered (340) by the generators having distinct frequencies ($F_x$,$F_y$);
d) the calculation means determine (360) the components of the ambient magnetic field along the axes of both conductive windings from the spectral components, at both distinct frequencies, of the signal provided by the scalar magnetometer in step c) and deduce therefrom the component orthogonal to these two axes from the module of the ambient magnetic field obtained in step b).

10. A method for measuring the components of an ambient magnetic field by means of the measuring device of claim 1, **characterised in that**:

a) both conductive windings are powered (420) by the generators having distinct frequencies ($F_x$,$F_y$), after said device is switched on;

b) the plane ($\Pi$) containing both axes of the conductive windings and the axis of the coil is swivelled, substantially orthogonally to the direction of the ambient magnetic field by minimizing the amplitudes of the components of the magneticfield measured along these two axes;

c) the calculation means determine (450) the module of the ambient magnetic field from the components having a zero frequency of the signal provided by the scalar magnetometer;

d) the calculation means determine (450) the components of the ambient magnetic field along the axes of both conductive windings from the spectral components, at both distinct frequencies, of the signal provided by the scalar magnetometer and deduce therefrom the component orthogonal to these two axes from the module of the ambient magnetic field obtained in step c).

11. The measuring method according to claim 10, **characterised in that** the spectral component at the zero frequency, $B_{eff}(0)$, is corrected beforehand by an offset equal to $\left( B_x^2 + B_y^2 \right) / 2 B_{eff}(0)$, where $B_x$ and $B_y$ are the components of the ambient magnetic field along the axes of both conductive windings.

12. The measuring method according to any of claims 9 to 11, **characterised in that** the calculation means determine a variation in the transfer function of the scalar magnetometer as a function of the frequency, correct (350, 440) said spectral components, at both distinct frequencies, to compensate for this variation, the components of the ambient magnetic field being then determined (360, 450) from the spectral components thus corrected.

FIG.1

FIG.2

```
┌─────────────────────────────────────────┐
│  détermination de la direction de B₀     │ ⟋⟍ 310
│ orientation du plan Π orthogonalement à B₀│
└─────────────────────────────────────────┘
                    │
                    ▼
        ┌───────────────────────┐
        │    mise sous tension   │  ⟋⟍ 320
        │ du magnétomètre vectoriel│
        └───────────────────────┘
                    │
                    ▼
        ┌───────────────────────┐
        │      mesure de B₀      │  ⟋⟍ 330
        │ par le magnétomètre scalaire│
        └───────────────────────┘
                    │
                    ▼
        ┌───────────────────────┐
        │   génération des signaux │  ⟋⟍ 340
        │  de modulation vectorielle│
        └───────────────────────┘
                    │
                    ▼
        ┌ ─ ─ ─ ─ ─ ─ ─ ─ ─ ─ ─ ─┐
        │ pré-traitement des composantes│  ⟋⟍ 350
        │ spectrales aux fréquences Fₓ,F_y│
        └ ─ ─ ─ ─ ─ ─ ─ ─ ─ ─ ─ ─┘
                    │
                    ▼
        ┌───────────────────────┐
        │ détermination des composantes│  ⟋⟍ 360
        │        Bₓ,B_y,B_z       │
        └───────────────────────┘
                    │
                    ▼
        ┌ ─ ─ ─ ─ ─ ─ ─ ─ ─ ─ ─ ─┐
        │ post-traitement des composantes│  ⟋⟍ 370
        │        Bₓ,B_y,B_z       │
        └ ─ ─ ─ ─ ─ ─ ─ ─ ─ ─ ─ ─┘
```

Étape 310: détermination de la direction de $B_0$, orientation du plan $\Pi$ orthogonalement à $B_0$ — 310

Étape 320: mise sous tension du magnétomètre vectoriel — 320

Étape 330: mesure de $B_0$ par le magnétomètre scalaire — 330

Étape 340: génération des signaux de modulation vectorielle — 340

Étape 350: pré-traitement des composantes spectrales aux fréquences $F_x$, $F_y$ — 350

Étape 360: détermination des composantes $B_x$, $B_y$, $B_z$ — 360

Étape 370: post-traitement des composantes $B_x$, $B_y$, $B_z$ — 370

## FIG.3

mise sous tension
du magnétomètre vectoriel        410

génération des signaux
de modulation vectorielle        420

orientation du plan Π orthogonalement à $\mathbf{B}_0$
par minimisation des composantes $B_x$ et $B_y$        430

pré-traitement des composantes
spectrales aux fréquences $0, F_x, F_y$        440

détermination du module $B_0$
et des composantes $B_x, B_y, B_z$        450

post-traitement des composantes
$B_x, B_y, B_z$        460

FIG.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2663430 A
- FR 2713347 A
- EP 964260 A
- EP 1344075 B

**Littérature non-brevet citée dans la description**

- **O. GAVRAND et al.** On the calibration of a vectorial He pumped magnetometer. *Earth Planet Space,* 2011, vol. 53, 949-958